**Europäisches Patentamt**

**European Patent Office**

**Office européen des brevets**

(19)

(11) **EP 1 168 459 A2**

(12) **EUROPEAN PATENT APPLICATION**

(43) Date of publication:
**02.01.2002 Bulletin 2002/01**

(51) Int Cl.7: **H01L 31/052**

(21) Application number: **01401500.2**

(22) Date of filing: **11.06.2001**

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI** | • **Setaka, Tatsuyuki,**<br>**NTT Power & Building Fac. Inc.**<br>**Tokyo (JP)**<br>• **Muroyama, Seiichi,**<br>**NTT Power & Building Fac. Inc.**<br>**Tokyo (JP)** |
| (30) Priority: **30.06.2000 JP 2000199584** | (74) Representative: **Signore, Robert et al**<br>**BREVALEX 3, rue du Docteur Lanceraux**<br>**75008 Paris (FR)** |
| (71) Applicant: **NTT Power and Building Facilities Inc.**<br>**Tokyo (JP)** | |
| (72) Inventors:<br>• **Matsushima, Toshio,**<br>**NTT Power & Building Fac. Inc.**<br>**Tokyo (JP)** | |

(54) **Solar power generation device**

(57)    A solar power generation device includes a power generation assembly (10, 20, 30, 40) having a light receiving surface (10a, 20a, 30a, 40a) and a reflector (11, 21, 31, 41) having a reflection surface (11a, 21a, 31a, 41a). The power generation assembly generates power by receiving sunlight by means of the light receiving surface and the reflection surface of the reflector reflects sunlight toward the light receiving surface. The reflection surface of the reflector is disposed so as to be inclined downwardly toward the light receiving surface of the power generation assembly at a predetermined angle of inclination. The length of the reflection surface is defined by the angle of inclination and the height of the receiving surface of the power generation assembly as variables.

# FIG. 1A

**EP 1 168 459 A2**

# FIG.1B

**Description**

BACKGROUND OF THE INVENTION

Field of the Invention

The present invention relates to a solar power generation device which converts light energy from the sun into electric power. More specifically, the present invention relates to a solar power generation device which is provided with a reflector for reflecting sunlight so that the reflected light may be used for power generation.

Description of Related Art

In general, a solar power generation device generates electric power when sunlight strikes semiconductors placed in a plurality of solar cells which form a solar battery so that electrons ejected from the semiconductors by the sunlight may flow through an external circuit and provide electric power. Accordingly, by using a solar power generation device, no pollutants, such as carbon dioxide, which are hazardous to the environment, are generated, whereas such pollutants may be generated when thermal power plants are employed. Therefore, the solar power generation device is a clean power generation device which is very environmentally friendly. For this reason, various applications of solar power generation devices have been studied, and applications as a power source for various devices or as a small power generation device used for homes have been realized.

In order to obtain electric power by sunlight striking a solar battery, it is necessary to impart energy to electrons of the semiconductors present in the filled band to move into the conductor band. Among light rays of various wavelengths which are contained in sunlight, only light having certain wavelengths is absorbed by the semiconductor and is used for the transfer of the electrons. More specifically, depending on the types of material used for the solar battery, light having wavelengths which contain energy necessary for exciting electrons thereof becomes necessary. For instance, in a solar cell formed of a silicon type material, light having a wavelength of 0.4 - 1.1μm for the crystalline type and of 0.4 - 0.7 μm for the amorphous type are used for power generation. Of sunlight reaching the ground (about 1 kW/m$^2$ when the intensity of solar radiation is high), about 15% may be converted into electric power by the crystalline type solar battery and about 10% may be converted into electric power by the amorphous type solar battery.

In a solar power generation device, plural solar cells, the number of which corresponds to a desired load, having the above-mentioned power generation characteristics, are connected in series and/or in parallel so as to be arranged on a planar surface so that desired amounts of electric power may be obtained. The solar battery is disposed at a constant angle of elevation, for instance, 30°, with its light receiving surface directed south in order to effectively receive sunlight. Since the output of the solar battery is proportional to the transfer quantity of electrons, i.e., the intensity of light, the output of the battery increases as the intensity of the solar radiation increases. Normally, the output of a solar battery when irradiated by the above-mentioned light of about 1 kw/m$^2$ is regarded as the rated output, and a system having a desired power generation capacity is assembled based on the value of the rated output.

In conventional solar power generation devices, the area of the light receiving surface is directly proportional to the power generation output. For this reason, it is necessary to combine a plurality of solar batteries in accordance with their levels of output to form a power generation assembly having a large light receiving surface in order to obtain a large output. Currently, although studies have been made to improve the power generation efficiency of solar batteries, the conversion efficiency to electric power is about 12%, and no solar battery having high power generation efficiency at practical cost has yet been realized. Accordingly, if a power generation system of the large output type is constructed, the size of the power generation assembly becomes very large and significantly increases the system cost. Also, although attempts have been made to decrease the area of the power generation assembly by condensing sunlight and irradiating it onto a solar battery, there are problems such as the system tends to be complicated due to the necessity of a device capable of tracking the sun, and it is difficult to decrease the cost of the system.

SUMMARY OF THE INVENTION

The present invention takes into consideration the above-mentioned circumstances, and it is an object thereof to provide a solar power generation device by which it becomes possible to decrease the area of a light receiving surface of a power generation assembly, which is necessary for obtaining a certain output, and to reduce the overall cost of the device.

The present invention provides a solar power generation device including a power generation assembly, which generates power by receiving sunlight by means of a light receiving surface, and a reflector having a reflection surface, which reflects sunlight toward the light receiving surface. The reflection surface of the reflector is disposed so as to be inclined downwardly toward the light receiving surface of the power generation assembly at a predetermined angle of inclination. The length of the reflection surface is defined by the angle of inclination and the height of the receiving surface of the power generation assembly as variables.

According to the above solar power generation device, by effectively projecting the direct light from the sun as well as light reflected by the reflector to the light receiving surface of the power generation assembly, it becomes possible to obtain an increase in output of the device similar to a case where the area of the light receiving surface of the power generation assembly is enlarged. Also, by determining the length of the reflection surface by using the angle of inclination of the reflection surface and the height of the light receiving surface of the power generation assembly as variables, the size of the reflector is limited to the range effective for the light receiving surface and it becomes possible to lower the increase in cost due to the reflector. Accordingly, the area of the light receiving surface of the power generation assembly necessary for obtaining a predetermined output may be decreased, and hence, the cost required for the entire device can be easily lowered.

In accordance with another aspect of the invention, the length of the reflection surface is defined by the formula:

$$L = H/\tan (\beta - \alpha)$$

where L indicates the length of the reflection surface, H indicates the height of the light receiving surface, $\alpha$ indicates the angle of inclination of the reflection surface, and $\beta$ indicates the angle of incidence of sunlight with respect to the horizontal plane.

In yet another aspect of the invention, the maximum angle of inclination of the reflection surface is about 30° and the maximum length of the reflection surface is about six times longer than the height of the light receiving surface.

In yet another aspect of the invention, the power generation assembly includes a plurality of solar cells, each of the plurality of solar cells being capable of generating power by receiving sunlight, and among the plurality of solar cells, those placed at substantially the same height in the vertical direction of the power generation assembly are connected in series so as to form cell groups placed at different heights so that power may be generated independently by each of the cell groups.

According to the above solar power generation device, it becomes possible to generate power independently by each of the cell groups, in which a plurality of solar cells placed at substantially the same height is connected in series. Therefore, even when the angle of incidence of the sun is low and a part of the light receiving surface is shaded by a part of the reflector, it is possible to obtain power from the cell groups which are not shaded because of the difference in the height of placement.

In yet another aspect of the invention, the solar power generation device further includes a transmission plate which is capable of transmitting sunlight to at least one of the light receiving surface of the power generation assembly and the reflection surface of the reflector.

In yet another aspect of the invention, the transmission plate is capable of absorbing light within a long wavelength region and transmitting light within other wavelength regions.

According to the above solar power generation device, it becomes possible to maintain a desired power generation condition of the device for a long period of time since the transmission plate absorbs light within a long wavelength region and transmits light within other wavelength regions so that the temperature increase in the light receiving surface of the power generation assembly and a lowering in the power generation efficiency of the device are prevented.

In yet another aspect of the invention, the transmission plate is disposed so as to cover the reflection surface of the reflector so that a space is formed surrounded by the transmission plate, the reflection surface, and the light receiving surface.

In yet another aspect of the invention, a liquid is contained and is sealed in the space.

According to the above solar power generation device, by placing the transmission plate so as to cover the reflection surface and sealing the liquid in the space surrounded by the light receiving surface, the reflection surface, and the transmission plate, it is possible to facilitate the generation of total reflection inside the transmission plate . Accordingly, it becomes possible to improve the power generation efficiency of the device by reflecting the light repeatedly between the reflection plate and the transmission plate and effectively condensing the sunlight.

In yet another aspect of the invention, the liquid contains a material which is capable of absorbing light within a long wavelength region.

In yet another aspect of the invention, the material capable of absorbing light within a long wavelength region is carbon dioxide.

According to the above solar power generation device, by adding a material which absorbs light within a long wavelength region to the liquid contained in the space, it becomes possible to maintain a desired power generation state of the device for a long period of time since the temperature increase in the light receiving surface of the power generation assembly and a lowering in the power generation efficiency of the device may be prevented by the effect of the material.

BRIEF DESCRIPTION OF THE DRAWINGS

Some of the features and advantages of the invention have been described, and others will be apparent from the detailed description which follows and from the accompanying drawings, in which:

FIG. 1A is a diagram showing the appearance of a solar power generation device according to the first embodiment of the present invention;
FIG. 1B is a diagram showing a side view of the solar power generation device according to the first embodiment of the present invention;
FIG. 2 is a diagram for explaining the formula used for defining the length of a reflection surface in the solar power generation device;
FIG. 3 is a diagram showing a state in which a plurality of the above-mentioned devices, having the structure shown in FIG. 1, is arranged in a row;
FIG. 4 is a diagram showing a side view of the solar power generation device in relation to a state in which the angle of incidence of sunlight is low;
FIG. 5 is a diagram showing a state in which a plurality of solar cells placed at substantially the same height are connected to each other in series in the horizontal direction;
FIG. 6 is a diagram showing a plurality of devices, having the structure shown in FIG. 5, is connected to each other;
FIG. 7A is a diagram showing the solar power generation device according to a second embodiment of the invention in which a transmission plate is placed so as to form a space having a substantially triangular cross section;
FIG. 7B is a diagram showing a solar power generation device according to the second embodiment of the invention in which the transmission plate is placed so as to cover a light receiving surface of a power generation assembly;
FIG. 8 is a diagram showing a solar power generation device according to the third embodiment of the present invention;
FIG. 9 is a diagram showing a solar power generation device according to the fourth embodiment of the present invention; and
FIG. 10 is a diagram showing the annual azimuth direction and the hourly altitude of the sun.

DETAILED DESCRIPTION OF THE INVENTION

The invention summarized above and defined by the enumerated claims may be better understood by referring to the following detailed description, which should be read with reference to the accompanying drawings. This detailed description of particular preferred embodiments, set out below to enable one to build and use particular implementations of the invention, is not intended to limit the enumerated claims, but to serve as particular examples thereof.

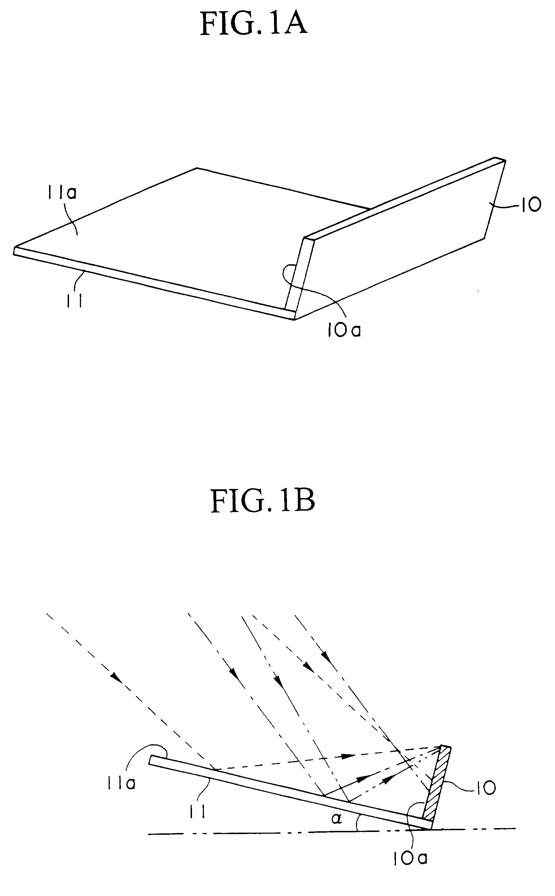

FIG. 1A is a diagram showing an appearance of a solar power generation device according to the first embodiment of the present invention. FIG. 1B is a diagram showing a side view of the solar power generation device according to the first embodiment. As shown in FIGS. 1A and 1B, the solar power generation device includes a power generation assembly 10 having a light receiving surface 10a and a reflector 11 having a reflection surface 11a. The power generation assembly 10 generates electric power by receiving sunlight by means of the light receiving surface 10a. The reflector 11 reflects sunlight toward the light receiving surface 10a of the power generation assembly 10 by means of the reflection surface 11a. In FIG. 1B, rays of sunlight incident on the reflector 11 at various incident angles and their reflection states are indicated by arrows.

The light receiving surface 10a of the power generation assembly 10 is disposed so as to have a constant elevation angle in a standing state with respect to the reflection surface 11a of the reflector 11. In this embodiment, the reflection surface 11a of the reflector 11 is disposed at an inclination angle $\alpha$ with respect to a horizontal plane so as to be directed downwardly to the light receiving surface 10a of the power generation assembly 10. The light receiving surface 10a of the power generation assembly 10 is disposed at the lower end of the inclined surface 11a at substantially a right angle to the reflection surface 11a. Accordingly, rays of sunlight may be incident on the light receiving surface 10a of the power genration assembly 10 directly as well as being reflected thereon by the reflection surface 11a of the reflector 11.

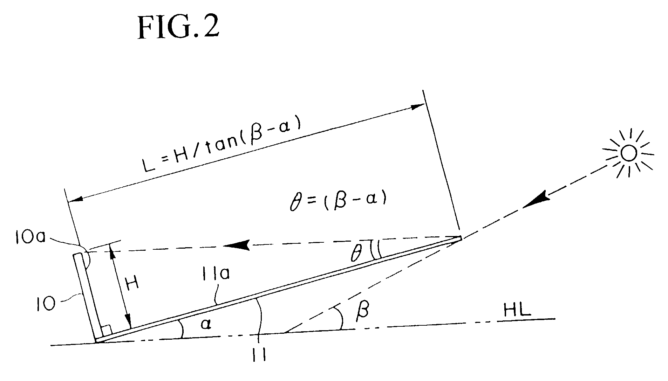

Also, as shown in Fig. 2, the length L of the reflection surface 11a in the inclination direction toward the ligth receiving surface 10a may be defined by the following formula (1) which includes the inclination angle $\alpha$, and the heigth H of the light receiving surface 10a of the power generation assembly 10, as variables:

$$L = H/\tan(\beta - \alpha) \qquad (1)$$

where β is the incident angle of sunlight with respect to the horizontal plane, and the height H of the light receiving surface 10a is the distance between the reflection surface 11a and the upper end of the light receiving surface 10a in the direction perpendicular to the reflection surface 11a in this embodiment.

The formula (1) defines the minimal length L of the reflection surface 11a which makes a light reflected by the reflection surface 11a effective with respective to the ligth receiving surface 10a. Tables 1 - 3 show results of calculating the length L of the reflection surface 11a for various incident angles β of sunlight based one the formula (1) when the inclination angle α of the reflection surface 11a is 0°, 20°, or 30°. Note that the relative incient angle of sunlight with respect to the relfection surface 11a is denoted by the symbol θ (i.e., relative incident angle θ, θ = β - α).

Table 1: Effective length L of the reflection surface with respect to the incident angle of sunlight (inclination angle α = 0°)

Table 1:

| Effective length L of the reflection surface with respect to the incident angle of sunlight (inclination angle α = 0°) | |
|---|---|
| Incident angle (β) | L |
| 10° | 5.67H |
| 20° | 2.74H |
| 30° | 1.73H |
| 40° | 1.19H |
| 50° | 0.83H |
| 60° | 0.57H |
| 70° | 0.36H |
| 80° | 0.17H |

Table 2:

| Effective length L of the reflection surface with respect to the incident angle of sunlight (inclination angle α = 20°) | | |
|---|---|---|
| Incident angle (β) | Relative incident angle (θ) | L |
| 10° | -10° | - |
| 20° | 0° | - |
| 30° | 10° | 5.67H |
| 40° | 20° | 2.74H |
| 50° | 30° | 1.73H |
| 60° | 40° | 1.19H |
| 70° | 50° | 0.83H |
| 80° | 60° | 0.57H |

Table 3:

| Effective length L of the reflection surface with respect to the incident angle of sunlight (inclination angle α = 30°) | | |
|---|---|---|
| Incident angle (β) | Relative incident angle (θ) | L |
| 10° | -20° | - |
| 20° | -10° | - |
| 30° | 0° | - |
| 40° | 10° | 5.67H |
| 50° | 20° | 2.74H |
| 60° | 30° | 1.73H |
| 70° | 40° | 1.19H |
| 80° | 50° | 0.83H |

As can be seen from Table 1, in the case in which the inclination angle $\alpha$ of the reflection surface 11a is 0°, the effective length L of the reflection surface 11a which is calculated based on the formula (1) becomes less than 60% with respect to the height of the light receiving surface 10a when the incident angle $\beta$ of sunlight becomes greater than 60°. In this case, it is considered that the effect of directing the reflected light reflected by the reflection surface 11a of the reflector 11 onto the light receiving surface 10a of the power generation assembly 10 decreases as the altitude of the sun increases. Therefore, by giving the reflection surface 11a an inclination angle $\alpha$ (for instance, $\alpha$ =20°, 30° and so forth) so that the angle of sunlight incident on the reflection surface 11a becomes relatively small, it becomes possible to obtain a sufficient length L of the reflection surface 11a which is effective for the light receiving surface 10a. In this manner, light reflected by the reflection surface 11 a is effectively directed onto the light receiving surface 10a of the power generation assembly 10 in addition to the incident light which comes directly from the sun.

That is, according to the solar power generation device of the invention having the above-described structure, it becomes possible to increase the quantity of light energy, which is received by the light receiving surface 10a by placing the reflection surface 11 a of the reflector 11 at a predetermined inclination angle $\alpha$ with respect to the horizontal plane so that the light reflected by the reflection surface 11a is effectively directed onto the light receiving surface 10a of the power generation assembly 10 as well as the light coming directly from the sun. In this manner, the power generation performance of the solar power generation device of the embodiment of the invention may be further increased as compared with conventional devices that utilize only direct light from the sun for generating power. That is, by using the light reflected by the reflector 11, it becomes possible to obtain an output increase, which is similar to the case in which the area of the light receiving surface 10a of the power generation assembly 10 is increased.

Also, in the solar power generation device, the length L of the reflection surface 11a is determined based on the formula (1), which includes the inclination angle $\alpha$ of the reflection surface 11a and the height H of the light receiving surface 10a as variables, and the formula (1) defines the minimal length L of the reflection surface 11a which makes light reflected by the reflection surface 11a effective with respective to the light receiving surface 10a. Accordingly, the size of the reflector 11 is limited to the range effective for the light receiving surface 10a, and hence, the increase in cost due to providing the reflector 11 may be minimized. Note that as shown in Tables 2 and 3, the length L of the reflection surface 11a is defined as being about 2 - 6 times of the height H of the light receiving surface 10a. Also, as will be described in the following embodiments, it is preferable to define, for instance, the inclination angle $\alpha$ of the reflection surface 11a as being about 20° or 30° at a latitude of about 35° north.

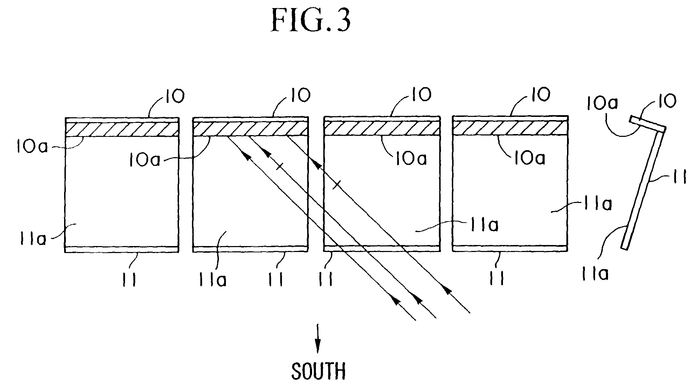

FIG. 3 is a diagram showing a state in which a plurality of the above-mentioned device, each of which includes the power generation assembly 10 and the reflector 11, is arranged in a row. In FIG. 3, each device is arranged adjacent to another in the east-west direction with the light receiving surface 10a of the power generation assembly 10 facing south so that the light receiving surface 10a of the power generation assembly 10 is placed parallel to the east-west direction. By arranging the plurality of devices in this manner, it becomes possible to receive not only light from the front of the device when the sun is at the meridian, but also light reflected by the reflector 11 of the other devices by means of the light receiving surface 10a when, for instance, the sun has a certain azimuth angle during the morning/afternoon period. For this reason, it becomes possible to increase the light condensing efficiency of the device and to supply more light to the light receiving surface 10a.

Also, in the above solar power generation device, by arranging the plurality of devices in a row, it is possible to receive the light from the sun by means of the light receiving surface 10a of the power generation assembly 10, even when the incident angle $\beta$ of the sunlight or the azimuth angle is changed, by reflecting the sunlight using the reflector 11. Accordingly, it is not necessary to install a device for tracking the sun.

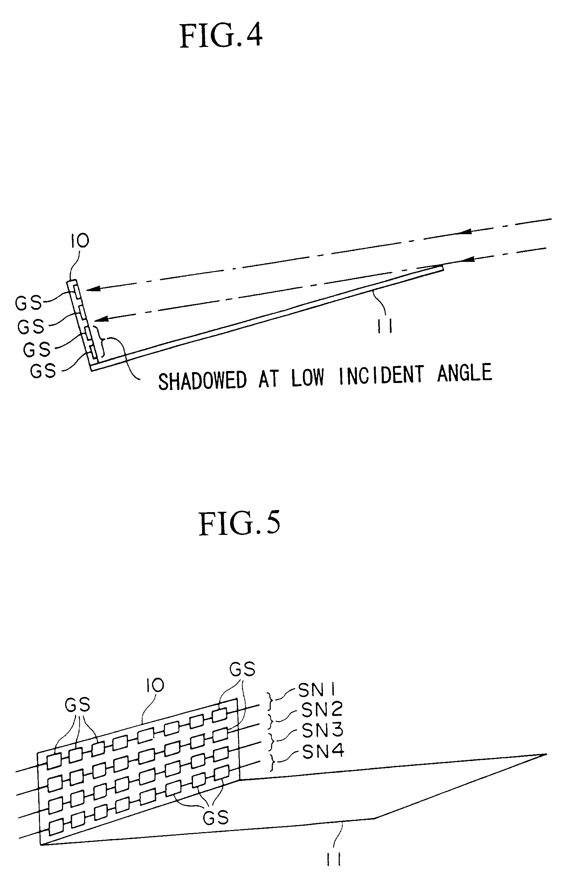

For the case where the inclination angle $\alpha$ of the reflection surface 11a is 30°, for instance, a part of the reflector 11 blocks sunlight when the incident angle $\beta$ of the sunlight is less than 30° as shown in FIG. 4. Accordingly, a part of the light receiving surface 10a of the power generation assembly 10 is shaded. Normally, each of the power generation assemblies 10 has plural solar cells GS which generate power when struck by sunlight. These solar cells GS are connected to each other and are arranged on a planar surface. For this reason, if a part of the light receiving surface 10a of the power generation assembly 10 is shaded, the shaded portion functions as a resistor and there is a risk that the flow of electric current will be inhibited at the shaded portion and the output of the solar system may be significantly reduced. Accordingly, it is preferable to connect the solar cells GS at about the same placement height in series when the power generation assembly 10 is constructed from a plurality of the solar cells GS.

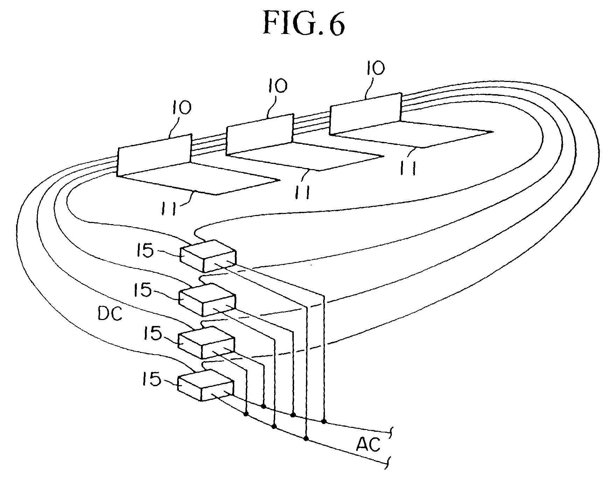

That is, as shown in FIG. 5, by placing a plurality of the solar cells GS at the same height in the horizontal direction so that they are connected to each other in series so as to form a cell group SN and by arranging a plurality of the cell groups SN (i.e., SN1 - SN4 in the figure) adjacent to each other in the height direction, it becomes possible to output electric power separately from each of the cell groups. In this configuration, since the light receiving surface 10a of the power generation assembly 10 is capable of generating electric power independently of the height thereof, an electric current flows easily through the non-shaded area of the light receiving surface 10a even if the incident angle of sunlight is low and a part of the reflector 11 blocks the sunlight, creating a shaded area on the light receiving surface 10a. In this way, it becomes possible not only to fully utilize the above-mentioned advantages obtainable by inclining the reflecting surface 11a but also to generate power for a longer part of the day. Note that when plural above-mentioned devices are arranged, it is possible to obtain the same effect by connecting cell groups at the same height as shown in FIG. 6. In FIG. 6, a plurality of inverters 15, which is provided for each of the cell groups placed at different heights, is also shown in addition to the power generation assemblies 10 and the reflectors 11.

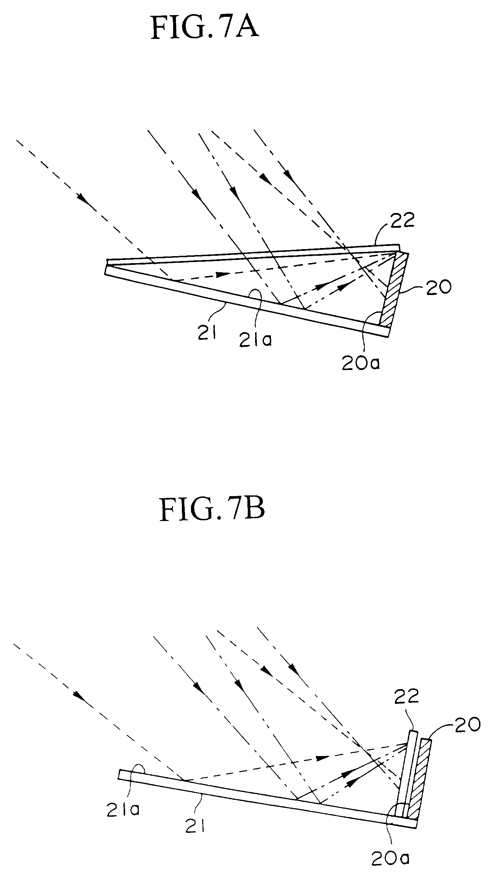

Next, a solar power generation device according to the second embodiment of the present is explained with reference to FIGS. 7A and 7B.

In the solar power generation device according to this embodiment, a transmission plate 22 is provided which absorbs light of long wavelengths (i.e., light having wavelengths which are long enough to cause an increase in the temperature of the solar cell GS, for instance, a light ray having a wavelength longer than 1.1μ m) incident on at least one of the light receiving surface 20a of the power generation assembly 20 and the reflection surface 21a of the reflector 21, and which allows transmission of light having shorter wavelengths. In this embodiment, an infrared absorption plate which absorbs infrared rays is used as the transmission plate 22. In FIG. 7A, an example in which the transmission plate 22 is placed so as to form a space having a substantially triangular cross-section is shown. In FIG. 7B, an example in which the transmission plate 22 is placed so as to cover the light receiving surface 20a of the power generation assembly 20 is shown.

In general, when the temperature of the power generation assembly 20 is increased, the power generation efficiency thereof tends to decrease. Therefore, by absorbing the light of long wavelengths using the transmission plate 22, it becomes possible to suppress the temperature increase of the power generation assembly 20 and prevent the decrease in the power generation efficiency. Also, the light having shorter wavelengths which passed through the transmission plate 22 reaches the light receiving surface 20a and is effectively utilized for power generation. Thus, according to the solar power generation device of the second embodiment of the present invention, it becomes possible to stably maintain a desired power generation state for a long period of time by absorbing infrared rays contained in sunlight by means of the transmission plate 22 and preventing the increase in the temperature of the power generation assembly 20.

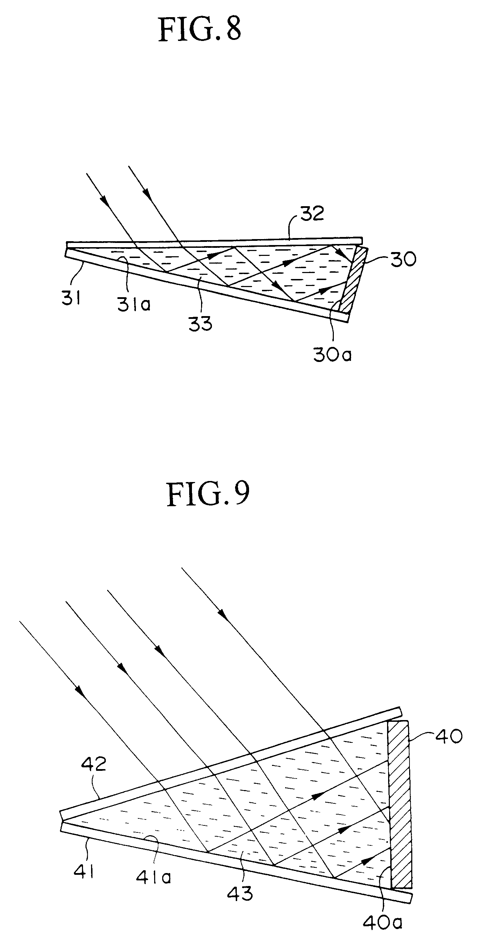

Next, a solar power generation device according to the third embodiment of the present invention will be described with reference to FIG. 8.

Similar to the device of the first embodiment, the solar power generation device of the third embodiment includes a light receiving surface 30a and a reflection surface 31 a. In addition, a transmission plate 32 which transmits light is provided with the device so as to cover the reflection surface 31a. The transmission plate 32 may be made of a member which absorbs the above-mentioned light of long wavelengths, or a normal transmission member 32 having high light transmittance. Also, a closed space 33, which is formed by the light receiving surface 30a, the reflection surface 31a, and the transmission plate 32, and has a substantially triangular cross-section, is provided with the solar power generation device. A liquid is sealed and contained in the space 33.

Since a liquid is contained in the space 33, the refractive index with respect to sunlight of the solar power generation device is increased, and hence, total reflection is readily generated by the inner side of the transmission plate 32. Accordingly, light reflected by the reflection surface 31a hardly escapes to the outside through the transmission plate 32 and is reflected by the transmission plate 32. In this manner, sunlight once entered into the liquid by passing through the transmission plate 32 is eventually guided to the light receiving surface 30a while being repeatedly reflected by the reflection plate 31a and the transmission plate 32. Therefore, it becomes possible to condense sunlight in a more efficient manner and improve the power generation efficiency of the device.

It is preferable to add materials, which are capable of absorbing light of long wavelengths, to the liquid contained in the space 32. Examples of such materials include carbon dioxide which is an infrared ray absorbent and is capable of being dissolved in the liquid. In this way, infrared rays contained in sunlight, which may be a cause of increased temperature of the light receiving surface 30a and decrease of the power generation efficiency, may be removed as the sunlight passes through the liquid.

Next, a solar power generation device according to the fourth embodiment of the present invention will be described with reference to FIG. 9.

Similar to the device of the third embodiment, the solar power generation device of the fourth embodiment includes a light receiving surface 40a, a reflection surface 41a, and a transmission plate 42. A space surrounded by these elements for containing a liquid is also provided with the device. Unlike the device of the third embodiment, the transmission plate 42 of this embodiment is disposed so as to be inclined with respect to the horizontal plane. That is, in the solar power generation device of the fourth embodiment, light from the sun reflected by the reflection surface 41a is readily directed towards the light receiving surface 40a since the transmission plate 42, which is provided so as to cover the reflection surface 41a, is inclined in the direction opposite to the reflection surface 41a with respect to the horizontal plane. Accordingly, it becomes possible to further improve the light condensing efficiency of the device for the light receiving surface 40a.

Note that the shape, the combinations, etc., of each component explained in the above-mentioned embodiments are merely examples and may be varied based on factors such as a design requirement as long as they are within the spirit and scope of the invention.

For instance, the present invention is applicable to solar batteries of any of the crystalline type silicon, amorphous type silicon, GaAs, CdTe, CdS and so forth. Also, according to an embodiment of the present invention, a battery whose main component is one of copper, indium, and selenium may be utilized. The present invention is particularly advantageous for the types of solar batteries whose performance is decreased by the temperature increase caused by the irradiation of infrared rays.

Next, actual examples of the solar power generation devices according to embodiments of the present invention will be described.

In the first case, a power generation assembly was constructed by using six silicon polycrystalline type solar batteries, each of which had the size of 12 cm X 12 cm, and a solar power generation device shown in FIG. 1 was assembled by using the power generation assembly. The size of a light receiving surface of the power generation assembly was 40 cm in width and 30 cm in height. Also, a mirror having a reflectance of 95% was used as a reflector, and based on the above-mentioned formula (1), the size of the reflection surface was determined to be 50 cm in width and 1800 cm in length. The solar power generation device was placed so that the angle of inclination of the reflection surface was 20°. Also, light having a light intensity of 1,000 W/cm$^2$ was irradiated onto the device from the front thereof at various angles of incidence by using a sunlight simulator, and the power generation characteristics of the device at a particular angle of incidence was measured. Results are shown in Table 4 below. Note that the angle of incidence of light was determined based on the horizontal plane

Table 4:

| Generated output obtained at various angles of incidence | | | | | | |
|---|---|---|---|---|---|---|
| Angle of incidence | 30° | 40° | 50° | 60° | 70° | 80° |
| Direct light to P.G.A.. (W) | 117 | 112 | 103 | 91 | 76 | 60 |
| Light reflected by reflector (W) | 111 | 106 | 98 | 87 | 73 | 57 |
| Total incident light to P.G.A.. (W) | 228 | 218 | 201 | 178 | 149 | 117 |
| Generated output (W) | 23 | 22 | 20 | 18 | 15 | 12 |
| P.G.A.: power generation assembly | | | | | | |

As it is clear from Table 4, since not only the direct light but also light reflected by the reflector strike the power generation assembly, the total light incident on the power generation assembly, and hence the output obtained therefrom, was nearly doubled as compared with a case where only the direct light was utilized. In order to make a comparison with the characteristics of the above device, a conventional solar power generation device was placed so that the elevation angle of the power generation assembly thereof was 30°. Light was irradiated over the device at different angles of incidence by using a sunlight simulator and the power generation characteristics of the device were measured. The results are shown in Table 5.

Table 5:

| Generated output obtained by a conventional solar power generation device | | | | | | |
|---|---|---|---|---|---|---|
| Angle of incidence | 30° | 40° | 50° | 60° | 70° | 80° |
| Direct light to P.G.A. (W) | 103 | 112 | 118 | 120 | 118 | 112 |
| Generated output (W) | 10 | 11 | 12 | 12 | 12 | 11 |
| P.G.A.: power generation assembly | | | | | | |

As can be seen from Table 5, the light incident on the power generation assembly was only the direct light, and about 10% of the energy thereof was converted into electric power. Also, about 10 W of electric power was obtained regardless of the angle of incidence of the light. Moreover, if a comparison is made about the power generation characteristics of the devices shown in Tables 4 and 5, it can be seen that the level of generated output is improved by the placement of the reflector according to the embodiment of the present invention. That is, by adopting the configuration of the device shown in FIG. 1, it becomes possible to improve the power generation capacity of the device per unit area.

Next, the cost relating to a facility required for obtaining a predetermined output was studied in relation to the device according to an embodiment of the present invention and a conventional device.

Factors used for making the comparison of the device according to an embodiment of the present invention with the conventional device in the abovementioned study are shown in Table 6 below.

Table 6:

| Factors used for comparison | | |
|---|---|---|
| Present invention | Size of light receiving surface | 40 cm width, 30 cm height |
| | Reflection surface | Mirror of 95% reflectance |
| | Size of reflection surface | 50 cm width, 900 cm length |
| | Inclination of reflection surface | 30° |
| Conventional art | Size of light receiving surface | 50 cm width, 900 cm length |

The results of trial calculations obtained by using the above-mentioned factors of the device are shown in Table 7.

Table 7:

| Comparison of the characteristics of the solar power generation device according to the present invention with that of the conventional art | | |
|---|---|---|
| | Present invention | Conventional art |
| Light receiving surface area per S.P.G.D. (Net area of P.G.P.) (cm$^2$) | 1,200 | 3,600 |
| Generated output per S.P.G.D. | 20 | 36 |
| Power generation density (W/cm$^2$) (when 1,000 w/cm$^2$) | 0.018 | 0.01 |
| S.P.G.D.: solar power generation device; P.G.P.: power generation part | | |

Also, based on the results shown in Table 7, an estimate of the facility per 1 kW output was estimated. The results are shown in Table 8.

Table 8:

| Estimate of facility for 1 kW output | | | |
|---|---|---|---|
| | No. of devices req.d for 1 kW P.G. | Light receiving surface Area req.d for 1 kW P.G. (Net area of P.G.P.) (cm$^2$) | Facility area req.d for 1 kW P.G. (cm$^2$) |
| Present invention | 45 | 54,545 | 162,000 |
| Conventional art | 28 | 100,800 | 100,800 |
| P.G.: power generation; P.G.P.: power generation part; req.d: required | | | |

As shown in Table 8, according to the solar power generation device of an embodiment of the present invention, the area of the light receiving surface (the net area of the power generation part) necessary for obtaining a predetermined output is decreased to about 1/2, as compared with that of a conventional device, due to the increase in the power generation capacity of the device per unit area. In general, since a majority of the facility cost is due to the expensive solar batteries in a system using a solar power generation device, it becomes possible to significantly reduce the facility cost if the area of the light receiving surface is reduced. Also, since the facility area required by an embodiment of the present invention is about 1.6 times larger than that required conventionally, the present invention is more advantageous where the freedom in choosing the installation area is large.

Next, outputs of the device obtained when the angle of inclination of the reflection surface is varied between 10° and 30° are shown in the following Table 9.

### Table 9: Generated output obtained when the angle of inclination of the reflection surface is varied

| Incidence \ Inclination | 10° | 20° | 30° |
|---|---|---|---|
| 30° | 22 | 23 | 12 |
| 40° | 20 | 22 | 23 |
| 50° | 18 | 20 | 22 |
| 60° | 15 | 18 | 20 |
| 70° | 12 | 15 | 18 |
| 80° | | 12 | 15 |

As can be seen from Table 9, when the angle of incidence of sunlight is varied (30° to 80°), the output generated at each angle of inclination (10°, 20°, and 30°) of the reflection surface is also changed. That is, in general, when the angle of incidence of sunlight is small, generated output becomes larger as the angle of inclination of the reflection surface becomes smaller, and when the angle of incidence is large, generated output becomes larger as the angle of inclination becomes larger. That is, it is preferable that the angle of inclination of the reflection surface of the reflector be determined in consideration of the altitude of the sun at the site where the device is to be installed.

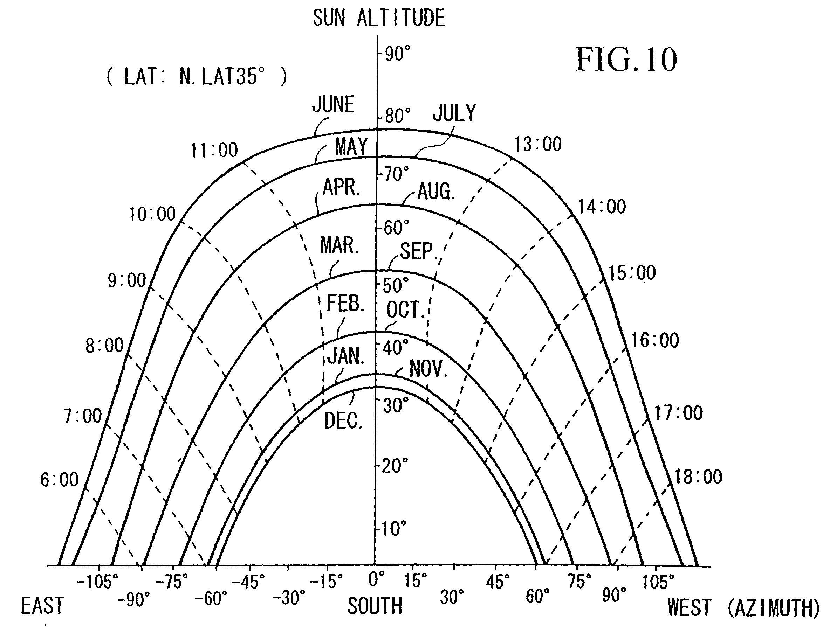

FIG. 10 is a diagram showing the annual azimuth direction and the hourly altitude of the sun at a site at latitude 35° north. As is clear from FIG. 10, the position of the sun at the meridian at the site at a latitude of 35° north is in the range between 30° and 80°. Also, the altitude of the sun exceeds 70° only in the months from May through July during the two hours between 11:00 and 13:00. Moreover, even within this three-month period, the altitude of the sun is relatively low at times other than the period mentioned above. Further, the altitude of the sun is less than 70° in periods other than the above-mentioned three-month period all day. It is considered that the angle of inclination of the reflection surface of the reflector is preferably between about 20° and 30°.

Next, a case was examined in which an infrared absorption plate (i.e., a transmission plate which absorbs light within a long wavelength region) was disposed at the upper portion of the reflector.

The same device, which was used in the above-mentioned example, was also used for this case and the infrared absorption plate was disposed so as to cover the reflection surface. The infrared absorption plate used was a so-called "heat reflecting glass", and in this case, a solar control glass was employed. By using the solar control glass, the amount of infrared rays transmitted was decreased and the temperature increase in the power generation assembly was lowered by about 10°C. The power generation assembly used in this case was formed by silicon polycrystalline type solar batteries whose power generation efficiency is known to be decreased when the temperature thereof increases. In general, the power generation efficiency of a device at 25°C is used as a standard. In this case, when the infrared absorption plate was not employed, the power generation efficiency of the solar power generation device was about 12%, and this value was reduced by about 4% when the temperature thereof reached 60°C during use. On the other hand, when the infrared absorption plate was employed, the power generation efficiency of about 11% was obtained due to the satisfactory inhibition of the temperature increase of the power generation assembly.

Next, studies were conducted for a case where a liquid containing an infrared absorbent was sealed in a space surrounded by the power generation assembly and the reflector.

In this case, a container having a high degree of air tightness was constructed by using a light transmitting partition wall, which was disposed so as to overlap with the light receiving surface of the power generation assembly, the reflector, and a phototransmission plate. An aqueous solution containing an infrared absorbent was sealed inside the container. In this case, carbon dioxide was selected and was used as the infrared absorbent, and the aqueous solution was saturated therewith. In this manner, the amount of infrared rays transmitted was reduced, and as in the above-mentioned example in which the infrared absorption plate was employed, a power generation efficiency of the device of about 11% was obtained.

Having thus described example embodiments of the invention, it will be apparent that various alterations, modifications, and improvements will readily occur to those skilled in the art. Such alterations, modifications, and improvements, though not expressly described above, are nonetheless intended and implied to be within the spirit and scope of the invention. Accordingly, the foregoing discussion is intended to be illustrative only; the invention is limited and defined only by the following claims and equivalents thereto.

**Claims**

1. A solar power generation device, comprising:

    a power generation assembly (10,20, 30, 40) which generates power by receiving sunlight by means of a light receiving surface (10a, 20a, 30a, 40a); and
    a reflector (11, 21, 31, 41) having a reflection surface (11a, 21a, 31a, 41a) which reflects sunlight toward said light receiving surface,

    wherein said reflection surface of said reflector is disposed so as to be inclined downwardly toward said light receiving surface of said power generation assembly at a predetermined angle of inclination, the length of said reflection surface being defined by the angle of inclination and the height of said receiving surface of said power generation assembly as variables.

2. A solar power generation device according to claim 1,
    wherein the length of said reflection surface is defined by the formula:

$$L = H/\tan (\beta - \alpha)$$

    where L indicates the length of said reflection surface, H indicates the height of said light receiving surface, $\alpha$ indicates the angle of inclination of said reflection surface, and $\beta$ indicates the angle of incidence of sunlight with respect to the horizontal plane.

3. A solar power generation device according to claim 1 or 2,
    wherein the maximum angle of inclination of said reflection surface is about 30° and the maximum length of said reflection surface is about six times longer than the height of said light receiving surface.

4. A solar power generation device according to any one of claims 1 - 3,

    wherein said power generation assembly comprises a plurality of solar cells, each of said plurality of solar cells being capable of generating power by receiving sunlight; and
    among said plurality of solar cells, those placed at substantially the same height in the vertical direction of said power generation assembly are connected in series so as to form cell groups each placed at a different height so that power may be generated independently by each of said cell groups.

5. A solar power generation device according to any one of claims 1 - 4, further comprising:

    a transmission plate (22, 32, 42) which is capable of transmitting sunlight to at least one of said light receiving surface of said power generation assembly and said reflection surface of said reflector.

6. A solar power generation device according to claim 5,
    wherein said transmission plate is capable of absorbing light within a long wavelength region and transmitting light within other wavelength regions.

7. A solar power generation device according to claim 5 or 6,
    wherein said transmission plate is disposed so as to cover said reflection surface of said reflector so that a space (33, 43) is formed surrounded by said transmission plate, said reflection surface, and said light receiving surface.

8. A solar power generation device according to claim 7, wherein a liquid is contained and sealed in said space.

9. A solar power generation device according to claim 8,

wherein said liquid contains a material which is capable of absorbing light within a long wavelength region.

10. A solar power generation device according to claim 9,
    wherein said material capable of absorbing light within a long wavelength region is carbon dioxide.

# FIG.1A

# FIG.1B

FIG.2

EP 1 168 459 A2

FIG.3

# FIG.4

SHADOWED AT LOW INCIDENT ANGLE

# FIG.5

FIG.6

## FIG.7A

## FIG.7B

# FIG.8

# FIG.9

FIG.10